# EUROPEAN PATENT APPLICATION

(11) **EP 1 263 035 A1**
(43) Date of publication of application: **04.12.2002**
(21) Application number: 02100510.3
(22) Date of filing: 20.05.2002
(51) Int. Cl.: H01L 21/768

(54) **Method for sealing via sidewalls in porous low-k dielectric layers**

(30) Priority: 23.05.2001 US 863687
(71) Applicant: Texas Instruments Incorporated, Dallas, Texas 75251 (US)
(72) Inventor: JIANG, Qiang-Tang, Austin, TX 78735 (US); BRENNAN, Kenneth D., Austin, TX 78748 (US)
(74) Representative: Holt, Michael

(57) **Abstract**

A method for completing an integrated circuit in the horizontal surface of a semiconductor substrate having interconnecting metal lines (102), comprising the steps of forming a dielectric layer (103) over a said substrate; etching a substantially vertical hole (105) into said dielectric layer so that it exposes one of said metal lines; depositing a barrier layer (201) over said structure including within said hole, said barrier layer operable to seal said dielectric sidewalls of said structure; selectively removing said barrier layer from the bottom of said hole, thereby exposing said metal line; and forming a copper interconnect structure in said structure, contacting said metal line.

## Description

### FIELD OF THE INVENTION

The present invention is related in general to the field of electronic systems and semiconductor devices, and more specifically to processes in integrated circuit fabrication aiming at reliable multi-level copper metallization.

### DESCRIPTION OF THE RELATED ART

In the last few years, copper interconnection has been adapted to silicon integrated circuits due to its low resistance and high electromigration reliability compared to the traditional aluminum interconnection. Single-damascene and dual-damascene methods have been employed for the fabrication of copper interconnection. For multi-level copper interconnects using any of these two methods, improved electromigration reliability, especially improved lifetime of early failures have been reported, for example, in the recent article "A High Reliability Copper Dual-Damascene Interconnection with Direct-Contact Via Structure" (K. Ueno et al, IEEE Internat. Electron Devices Meeting 2000, Dec.10-13, pp. 265-268). In the technique described, the improvement in multi-level copper circuits has been achieved by making the copper contacts on the bottom of interconnecting vias barrier-free except for an ultra-thin adhesion layer.

In spite of progress such as described in that paper, in known technology many problems still remain related to the copper interconnection concept. For example, the copper traces have to be sealed by barrier layers in order to prevent copper migration into the silicon circuitry where copper atoms are known to offer energy levels for electron recombination/generation, acting as electron life-time killers. The same sealing barriers should protect the porous insulating layers of low dielectric constant (so-called low-k materials) against intruding atoms, which may initiate coalescence of micro-voids into larger voids.

As an additional example, in the preparation process of copper-filled trenches and vias, care has to be taken to prepare the via linings so that copper resistivity is prevented from increasing inordinately when the trench/via diameter is shrinking. No attention has been given, however, to practical methods such as whether the trench/via fabrication steps are cost-effective and simple enough for easy clean-up after via preparation.

An urgent need has, therefore, arisen for a coherent, low-cost method of fabricating copper-filled interconnection in single and dual damascene copper metallization and, simultaneously, improve the degree of component reliability. The fabrication method should be simple, yet flexible enough for different semiconductor product families and a wide spectrum of design and process variations. Preferably, these innovations should be accomplished without extending production cycle time, and using the installed equipment, so that no investment in new manufacturing machines is needed.

### SUMMARY OF THE INVENTION

The invention describes a method for completing an integrated circuit in the horizontal surface of a semiconductor substrate having interconnecting metal lines, comprising the steps of forming a dielectric layer over a said substrate; etching a substantially vertical hole into said dielectric layer so that it exposes one of said metal lines; depositing a barrier layer over said dielectric layer including within said hole, said barrier layer operable to seal said dielectric layer; selectively removing said barrier layer from the bottom of said hole, thereby exposing said metal line; and forming a copper interconnect structure in said hole, contacting said metal line.

The barrier deposition and etching method described by the invention is applicable to any dielectric layer, but especially to porous materials of low dielectric constants.

The barrier materials acceptable by the invention include many dielectric materials and refractory metals, compounds such as dielectric and metal carbides and nitrides. The barrier layers have a thickness in the range from 1 to 50 nm.

As a technical advantage of the invention, the barrier layers offer easy chemical clean-up after completing the selective barrier removal process in order to selectively remove the barrier from the bottom of the vias.

As a further technical advantage of the invention, the barriers further offer effective seals of the dielectric layers to prevent micro-voids within the porous dielectric layers from coalescing into larger voids.

For the composite structure of a trench-level dielectric and a via-level dielectric, coupled by a middle stop layer, the process step of selectively removing the barrier layer on the bottom of the via comprises a fine-tuned anisotropic plasma etching process. According to the invention, the etch step is designed to remove the (generally horizontal) barrier portion on the bottom of the hole together with the (generally horizontal) barrier portions on the middle stop layer and penetrate only partially into the middle stop layer. Consequently, the remaining stop layer continues to seal the porous dielectric material.

It is an aspect of the invention that the method is fully compatible with single damascene and dual damascene process flow and deep sub-micron (0.18 µm and smaller) technologies.

The technical advances represented by the invention, as well as the aspects thereof, will become apparent from the following description of the preferred embodiments of the invention, when considered in conjunction with the accompanying drawings and the novel features set forth in the appended claims.

### BRIEF DESCRIPTION OF THE DRAWINGS

FIG. 1 shows a schematic cross section through the structure of a hole in a dielectric layer, made in dual-damascene technology.

FIGs. 2 to 4 illustrate the process flow of an interlevel connection according to the first embodiment of the invention.

FIG. 2A shows a schematic cross section through the hole of FIG. 1 after dielectric barrier deposition.

FIG. 2B shows the schematic cross section of FIG. 2A in a reduced scale.

FIG. 3A shows a schematic cross section though the hole of FIG. 2A after directional etch and via open.

FIG. 3B shows the schematic cross section of FIG. 3A in a reduced scale.

FIG. 4 shows a schematic cross section through the completed interlevel connection.

FIGs. 5 to 8 illustrate the process flow of an interlevel connection according to the second embodiment of the invention.

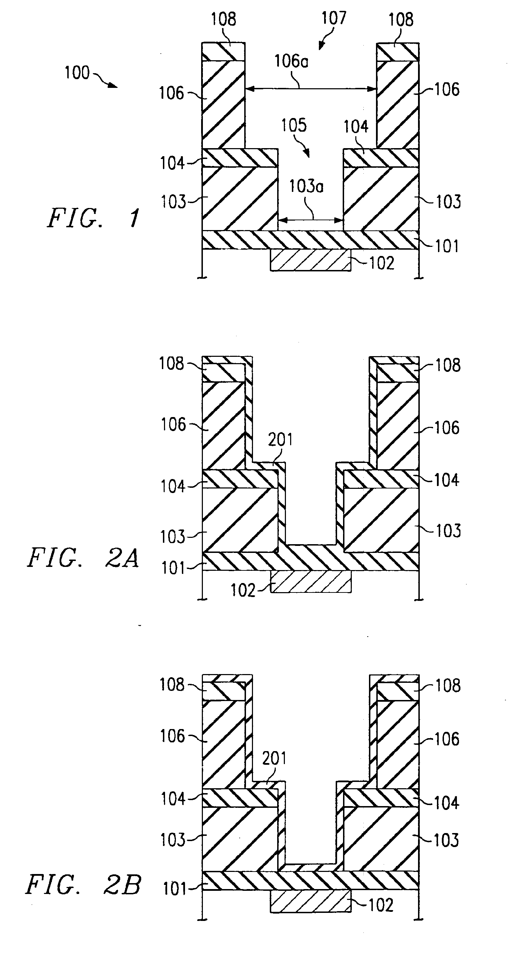

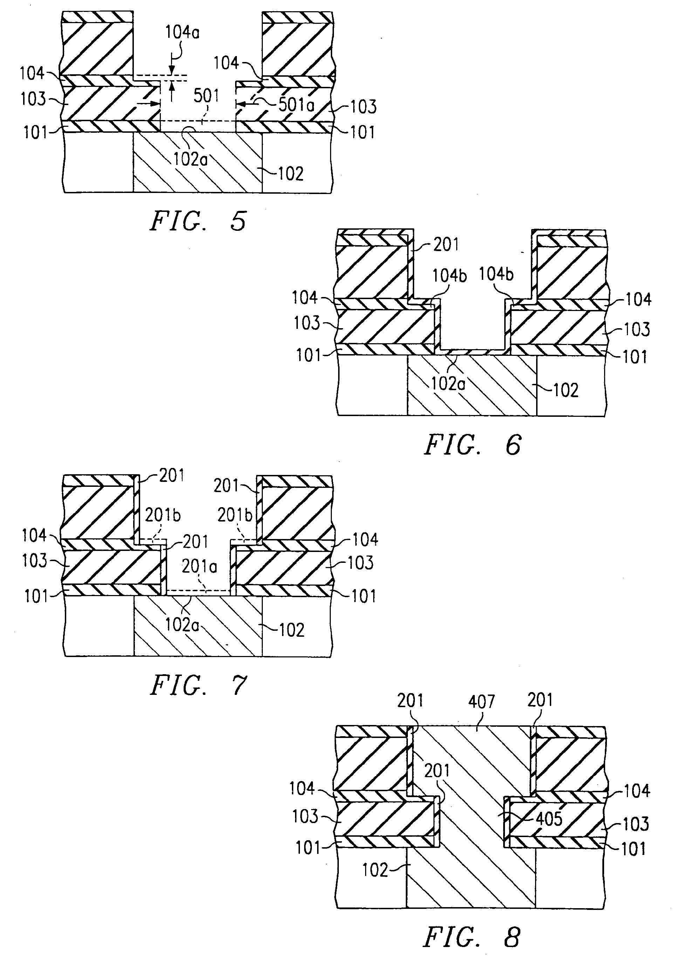

FIG. 5 shows a schematic cross section through the hole of FIG. 1 after the barrier layer over the metal line has been removed.

FIG. 6 shows a schematic cross section through the hole of FIG. 1 after dielectric barrier deposition.

FIG. 7 shows a schematic cross section through the hole of FIG. 5 after directional etch and via open.

FIG. 8 shows a schematic cross section through the completed interlevel connection.

### DETAILED DESCRIPTION OF THE PREFERRED EMBODIMENTS

Single-damascene and dual-damascene processes have been used to fabricate copper interconnections. This invention applies to both of these technologies. The dual-damascene technology has the advantage of reducing process steps which leads to lower cost. It is, therefore, chosen as the vehicle to describe the present invention. It should be stressed, however, that this invention applies also to the single-damascene technology.

FIG. 1 is a schematic representation of a dual-damascene interlevel structure, generally designated 100; FIG. 1 is generic and not to scale. A barrier layer 101 is positioned over the underlying metal line 102 (metal line 1). Line 102 is made of copper, and a preferred material for barrier 101 is silicon carbon nitride in the thickness range from 50 to 80 nm. It has been demonstrated that if the barrier layer 102 would be allowed to remain, it would increase the via resistance and potentially degrade the electromigration reliability, because copper flow would be blocked by the barrier and voids might be formed.

Over barrier layer 101 is the via-level dielectric 103. When a porous, low dielectric constant material is selected, a preferred thickness range is between 300 and 500 nm. Commercially materials are available under the brand name XLK 2.2 by Dow Corning, USA, or LKD 5109 by JSR, Japan. A hole 105, usually referred to as the "via", opens through the whole thickness of the via-level dielectric 103; it opens to the underlying metal line 102. The width 103a of the via depends on the prevailing technology node; a preferred width is 0.18 µm.

Over the via-level dielectric 103 is an etch stop layer 104, often referred to as Middle Stop Layer, or Trench Stop Layer. Preferred material is silicon carbide in the thickness range from about 30 to 80 nm; the thinner end of this range is preferred.

Over the Middle Stop Layer 104 is another layer 106 of dielectric material, referred to as the trench-level dielectric. For a porous, low dielectric material such as XLK 2.2 by Dow Corning or JSR film LKD 5109, the preferred thickness range is between 300 and 500 nm.

A hole 107, usually referred to as the "trench", opens through the whole thickness of the trench-level dielectric 106. The width 106a of the trench is typically O.2 µm, but the length could be much longer, dependent on the circuit design.

An insulating cap layer 108 completes the sequence of layer for this interlevel insulation stack. Preferred material for the cap layer is silicon carbide in the thickness range from 50 to 100 nm. Over the cap layer would be the next level metallization as line 2 (not shown in FIG. 1), again made of copper.

The hole, composed of trench 107 and via 105, is created by etches and ashes and is to be filled with copper in order to establish conductive interlevel connection between metal lines 1 and 2. Consequently, the hole has to be lined with a barrier capable of:
* Preventing the copper of the interconnecting plug to migrate into the interlevel dielectric layers;
* Protecting the porous low-k interlevel dielectric layers against penetrating atoms which might catalyze the growth of voids from the microvoids of the porous material;
* Making it easier to complete the step of clean-up after etch.

FIGs. 2 to 4 illustrate the process flow of producing an interlevel connection having the above features, according to the first embodiment of the invention: Depositing barrier before opening via.
- Depositing Barrier Layer ("Liner"):
   - FIG. 2A:: A barrier layer 201, called the "liner", is conformably deposited (by CVD) on the dual damascene structure shown in FIG. 1. The thickness of the liner is in the 1 to 50 nm range, preferably about 10 nm thick. In this thickness range, the liner gives good side wall coverage, while it is somewhat thicker on the bottoms of the via and the trench. The material of the barrier layer can be selected from a number of choices:

   * Insulating dielectric compounds:
      Silicon carbide, titanium nitride,
      tantalum nitride, tungsten nitride,
      tungsten carbide, silicon nitride, silicon carbon nitride, titanium silicon nitride, tantalum silicon nitride;
   * Refractory metal:
      Titanium, tantalum, tungsten, molybdenum, chromium, and compounds thereof; and
   * Composite layers of the above materials.
   Excellent results can be obtained for instance by Novellus silicon carbon nitride, which is differentiated from the silicon carbide of the Middle Stop layer and the Cap layer. Also, stacks of different layers (for instance, one dielectric and one refractory metal layer) have proven successful.
   - FIG. 2B repeats FIG. 2A,: slightly more simplified and on a reduced scale.
- Etching Side Wall and Barrier Layers:

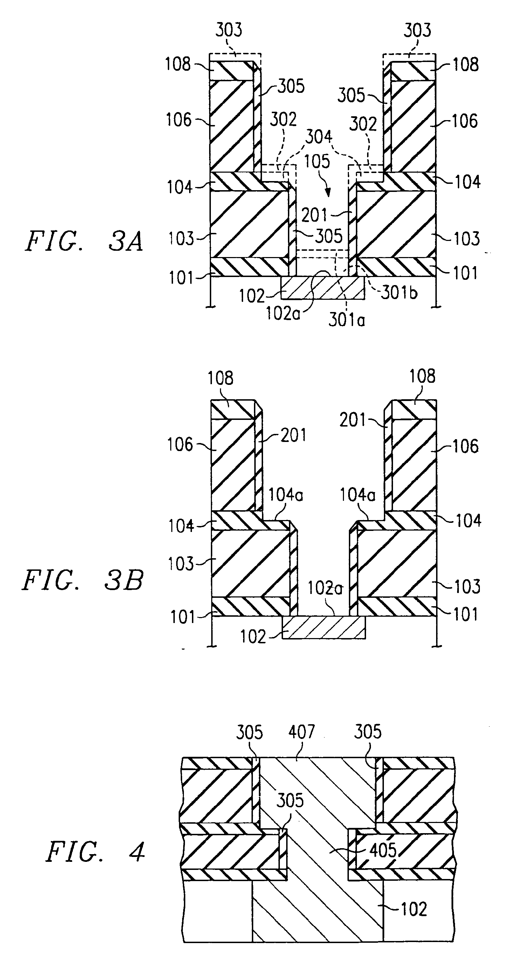

   - Fig. 3A:: * An anisotropic plasma etching process is used to selectively remove the barrier portions having a horizontal orientation, especially the portion 301a of the liner 201 and the portion 301b of the barrier layer 101, both preferably made of silicon carbon nitride. This etch step removes the insulators from the bottom of the via 105 and exposes the surface 102a of the metal line 102, and leaves the side walls 305 intact.

   * However, the same directional etch step
      removes horizontal liner portions 302
      positioned over middle stop layer 104 at the bottom of the trench, and horizontal liner portions 303 positioned over cap layer 108.
   * Layers 104 and 108 are preferably made of
      silicon carbide. Since especially middle
      stop layer 104 must survive the etch process intact to guarantee continued protection of
      the porous dielectric layers 103 and 106, the etch process has to be selective. A CH3F/Ar/
      O2, or a C4F8/Ar/N2 plasma provides the controlled removal of only a small portion
      304 of the middle stop layer 104.

   - FIG. 3B:: Repeats FIG. 3A, slightly more simplified and on a reduced scale. The via is completely open and exposes surface 102a of metal line 102, and middle stop layer 104 is only partially etched so that portions 104a survive the directional etch process intact.
- Filling trench 107 and via 105 with copper:
   - FIG. 4:: * Depositing copper seed metal on the side walls 305. It often proved beneficial to deposit first a thin glue layer of tantalum, titanium, titanium/titanium nitride, or tungsten. * Plating copper to create copper filling 407 in trench 107, and copper filling 405 in via 105. * Chemical/mechanical polishing. * Copper interlevel interconnect is completed. Fillings 407 and 405 are continuous with metal line 102.
   FIGs. 5 to 8 illustrate the process flow of producing an interlevel connection having the above quoted characteristics, according to the second embodiment of the invention: Barrier is deposited after opening via.
- Etching barrier layer:
   - FIG. 5:: Starting from the dual-damascene interlevel structure of FIG. 1, anisotropic plasma etching of barrier layer 101 selectively removes the barrier portion 501 located over metal line 102. The surface 102a of copper line 102 is now exposed for the length 501a of the via width. Note: The anisotropic plasma etching also selectively removes thickness portion 104a of middle stop layer 104 without destroying the integrity of middle stop layer 104. Middle stop layer 104 continues to protect via level dielectric 103.
- Depositing "Liner":
   - FIG. 6:: Conformably depositing, by CVD, barrier layer 201, called the "liner". Choice of material as listed in FIG. 2A, for example, silicon carbide. Liner 201 now covers surface 102a of metal line 102. Liner 201 also forms all barrier side walls and covers the thinned portion 104b of the middle stop layer 104.
- Selectively etching horizontal liner portions:
   - FIG. 7:: A directional plasma etch step removes the horizontal liner portions 201a from the bottom of the via and 201b from the thinned portions of the middle stop layer 104. The surface 102a of the copper line 102 is again exposed.
- Filling trench and via with copper:
   - FIG. 8:: The process steps for depositing glue layer, seed layer, and copper plating are identical to the ones listed under FIG. 4. After chemical/mechanical polishing, the copper interlevel interconnect is completed. Copper fillings 407 and 405 are continuous with metal line 102.

The interlevel interconnect created by the embodiments in FIG. 4 and FIG. 8 of the invention provide same-grain copper interface bonding and thus minimum via resistance. This fact, in turn, provides minimum interconnect Joule heating and optimal electromigration reliability.

When the via and trench side wall are prepared according to the teachings of the invention, the copper shows improved adhesion to the side walls of the trenches and vias, while it is prevented from diffusing into the inter-layer and intra-layer dielectrics. Furthermore, formation of sizeable voids in the porous low-k dielectrics is not observed, indicating that the liner are good barriers along the vias and trenches against intruding unwanted atoms.

The processes as described for the embodiments of the invention do not require processes or tools other than those already in existence in current copper fabs.

Experience has shown that the liner walls as prepared by this invention provide an easier clean-up (for example, by argon sputter clean or any wet and/or dry cleans) after plasma etch. As a consequence, the subsequent metal deposition is more controlled and reliable, resulting in product with longer life in electromigration testing and lower electrical resistance.

While this invention has been described in reference to illustrative embodiments, this description is not intended to be construed in a limiting sense. Various modifications and combinations of the illustrative embodiments, as well as other embodiments of the invention, will be apparent to persons skilled in the art upon reference to the description. One example is the choice of sandwiched liner materials to further enhance copper adhesion to the liner walls, while simultaneously creating smooth wall surfaces for minimizing copper resistance. Another example is the fine-tuning of the anisotropic plasma etch to achieve specific side wall structures when the via diameter is scaled down with the shrinking feature sizes of the integrated circuit designs. It is therefore intended that the appended claims encompass any such modifications or embodiments.

## Claims

1. A method for completing an integrated circuit in the horizontal surface of a semiconductor substrate having interconnecting metal lines, comprising the steps of:
forming a dielectric layer over a said substrate;
etching a substantially vertical hole into said dielectric layer so that it exposes one of said metal lines;
depositing a barrier layer over said dielectric layer including within said hole, said barrier layer operable to seal said dielectric layer;
selectively removing said barrier layer from the bottom of said hole, thereby exposing said metal line; and
forming a copper interconnect structure in said hole, contacting said metal line.

2. The method according to Claim 1 wherein said dielectric layer is made of a porous material of low dielectric constant.

3. The method according to Claim 1 wherein said barrier layer is made of a refractory metal selected from a group consisting of titanium, tantalum, tungsten, molybdenum, chromium, and compounds thereof.

4. The method according to Claim 1 wherein said barrier layer is made of an insulating dielectric compound selected from a group consisting of silicon carbon nitride, silicon carbide, titanium nitride, tantalum nitride, tungsten nitride, tungsten carbide, silicon nitride, titanium silicon nitride, and tantalum silicon nitride.

5. The method according to Claim 1 wherein said barrier layer is made of an organic dielectric material.

6. The method according to Claim 1 wherein said barrier layer has a thickness in the range from 1 to 50 nm.

7. The method according to Claim 1 wherein said copper interconnect structure adheres well to said barrier layer.

8. The method according to Claim 1 wherein said barrier layer seals said dielectric layer so that micro-voids within said porous dielectric layer are prevented from coalescing into larger voids, and copper is prevented from migrating from said hole into said dielectric layer.

9. The method according to Claim 1 wherein said barrier layer further provides an easy chemical clean-up process after completing said selective barrier removal process.

10. The method according to Claim 1 wherein said hole comprises a trench.

11. The method according to Claim 1 wherein said hole comprises a trench and a via.

12. The method according to Claim 1 wherein said step of selectively removing said barrier layer comprises an anisotropic plasma etching process, which removes the generally horizontal barrier portion on the bottom of said hole.

13. The method according to Claim 1 wherein said interconnecting metal lines are made of copper.

14. A method of completing an integrated circuit in a semiconductor substrate having interconnecting metal lines, comprising the steps of:
forming an interlevel dielectric layer over said substrate;
forming an intrametal dielectric layer over said interlevel dielectric layer;
etching a trench into said intrametal dielectric layer and a via within said trench into said interlevel dielectric layer;
depositing a barrier layer within said trench and said via;
selectively removing said barrier layer from the bottom of said via, thereby exposing said metal line; and
forming a copper interconnect structure in said trench and said via, contacting said metal line.

15. The method according to Claim 14 wherein said interlevel dielectric layer is made of a porous material of low dielectric constant.

16. The method according to Claim 14 wherein said dielectric layer is made of a porous material of low dielectric constant.

17. The method according to Claim 14 wherein said barrier layer is made of a refractory metal selected from a group consisting of titanium, tantalum, tungsten, molybdenum, chromium, and compounds thereof.

18. The method according to Claim 14 wherein said barrier layer is made of an insulating dielectric compound selected from a group consisting of silicon carbon nitride, silicon carbide, titanium nitride, tantalum nitride, tungsten nitride, tungsten carbide, silicon nitride, titanium silicon nitride, and tantalum silicon nitride.

19. The method according to Claim 14 wherein said barrier layer is made of an organic dielectric material.

20. The method according to Claim 14 wherein said barrier layer has a thickness in the range from 1 to 50 nm.

21. The method according to Claim 14 wherein said copper interconnect structure adheres well to said barrier layer.

22. The method according to Claim 14 wherein said barrier layer seals said dielectric layer so that micro-voids within said porous dielectric layer are prevented from coalescing into larger voids, and copper is prevented from migrating from said hole into said dielectric layer.

23. The method according to Claim 14 wherein said barrier layer further provides an easy chemical clean-up process after completing said selective barrier removal process.

24. The method according to Claim 14 wherein said step of selectively removing said barrier layer comprises an anisotropic plasma etching process, which removes the generally horizontal barrier portion on the bottom of said hole.

25. The method according to Claim 14 wherein said interconnecting metal lines are made of copper.
